# EUROPEAN PATENT APPLICATION

(11) **EP 0 551 990 A1**
(43) Date of publication of application: **21.07.1993**
(21) Application number: 93300095.2
(22) Date of filing: 07.01.1993
(51) Int. Cl.: H04N 5/92, H04N 1/41, H04N 7/13

(54) **Digital video compression method and apparatus**

(30) Priority: 14.01.1992 US 820460
(71) Applicant: International Business Machines Corporation, Armonk, N.Y. 10504 (US)
(72) Inventor: Bridges, John, Costa Mesa, California 92626 (US); Rutherford, Charles Thomas, Delray Beach, Florida 33445 (US)
(74) Representative: Burt, Roger James, Dr.

(57) **Abstract**

This invention relates to the electronic storage and retrieval of sequences of digital video images, such as occur in digital motion video and frame animation computer applications. The method of the invention is a differential frame compression method in which a sequence of a plurality of video images each to be displayed in a predetermined array of pixels arranged in a succession of lines are provided; a first digital signal which represents a first video image in the sequence to be displayed is derived to have a bit-mask data portion defining an array of pixels and a pixel data portion defining pixel values for pixels within the bit-mask array and to be displayed; a second digital signal which represents a second video image in the sequence to be displayed and which is a successor to the first image is derived similarly to the first; the first and second digital signals are compared to distinguish pixel data which is unchanged in the succession from the first video image to the second video image; the second digital signal is compressed by deriving the bit-mask data portion thereof to represent which pixels are changed in the succession from the first video image to the second video image and by deriving the pixel data portion thereof to represent only those pixels which are represented in the bit-mask portion as being changed; and the series of digital signals are stored.

## Description

### Technical Field

This invention relates to the electronic storage and retrieval of sequences of digital video images, such as occur in digital motion video and frame animation computer applications. Specifically, it describes an interframe or differential image compression method and related apparatus.

### Background of the Invention

Personal computer systems in general and IBM personal computers in particular have attained widespread use for providing computer power to many segments of today's modern society. Personal computer systems can usually be defined as a desk top, floor standing, or portable microcomputer that consists of a system unit having a single system processor and associated volatile and non-volatile memory, a display monitor, a keyboard, one or more diskette drives, a fixed disk storage, and an optional printer. One of the distinguishing characteristics of these systems is the use of a motherboard or system planar to electrically connect these components together. These systems are designed primarily to give independent computing power to a single user and are inexpensively priced for purchase by individuals or small businesses. Examples of such personal computer systems are IBM's PERSONAL COMPUTER AT and IBM's PERSONAL SYSTEM/2 Models 25, 30, 35, 40, L40SX, 50, 55, 57, 65, 70, 80, 90 and 95.

These systems can be classified into two general families. The first family, usually referred to as Family I Models, use a bus architecture exemplified by the IBM PERSONAL COMPUTER AT and other "IBM compatible" machines. The second family, referred to as Family II Models, use IBM's MICRO CHANNEL bus architecture exemplified by IBM's PERSONAL SYSTEM/2 Models 50 through 95. The Family I models typically have used the popular INTEL 8088 or 8086 microprocessor as the system processor. These processors have the ability to address one megabyte of memory. The Family II models typically use the high speed INTEL 80286, 80386, and 80486 microprocessors which can operate in a real mode to emulate the slower speed INTEL 8086 microprocessor or a protected mode which extends the addressing range from 1 megabyte to 4 Gigabytes for some models. In essence, the real mode feature of the 80286, 80386, and 80486 processors provide hardware compatibility with software written for the 8086 and 8088 microprocessors.

Systems of the types described have been used, among other purposes, to receive, store, manipulate and display video images. Such video images can be provided, for example, from video cameras of studio or home entertainment types, from recorded video images stored as analog signals on magnetic tapes readable by video cassette recorders and players or the like, and from digitized video sources. Some familiar forms of images so stored and available for use with systems of the types described range from the video equivalent of home movies through video recorded films or movies (animated or of live actors) to live action video taken from direct broadcasts. Typically, because the computer systems involved are digital systems, video data stored in or handled by the systems is digitized or made digitally encoded in character as distinguished from analog in character (the later typically being frequency modulated).

The amount of digital data required to encode video data is very large, relative to other types of computer data, especially when spatial and color fidelity are preserved. For instance, a single image of 640 by 480 pixels, at 24 bits per pixel, takes almost 1 megabyte of memory to store. Because storage is costly, both in terms of capacity and speed, much work has been invested in data compression methods. Compression reduces the amount of digital data required to represent an image, lowering the cost of storing it, as well as the time it takes to store and retrieve it.

### Brief Description of the Invention

With the foregoing in mind, the present invention contemplates a method for compressing digitally encoded video image signals which represent a series of images. In realizing this purpose of the present invention, comparisons are made between the digital data which is representative of a succession of images in the series, and digital data which remains the same from one image in the series to an immediately following image is compressed. This differential frame encoding significantly lessens the amount of digital data which must be handled, moved, stored and retrieved in using a personal computer system to work with video image signals of the types described.

The present invention also contemplates the provision of a personal computer system particularly adapted to handle, move, store and retrieve video image signals of the types described. In realizing this purpose of the present invention, capability is achieved for more economical handling, storage and retrieval of motion video.

Further, the present subject invention contemplates the provision of digital storage devices bearing digital signals representative of digitally encoded video images, and the digital signals so encoded, which represent a series of images which have been compressed in a particular way which facilitates handling, storage and retrieval of the images represented.

### Brief Description of the Drawings

In the accompanying drawings:
Figure 1 is a perspective view of a personal computer embodying this invention;
Figure 2 is an exploded perspective view of certain elements of the personal computer of Figure 1 including a chassis, a cover, and a planar board and illustrating certain relationships among those elements;
Figure 3 is a schematic view of certain components of the personal computer of Figures 1 and 2;
Figure 4 is a schematic representation of two images or frames in a series of images to be displayed;
Figure 5 is a representation of a differential bit-mask indicating the pixels as to which there is change from the first image or frame of Figure 4 to the second image or frame of Figure 4; and
Figure 6 is a representation of a digital signal for the second image or frame of Figure 4 derived in accordance with this invention.

### Detailed Description of Invention

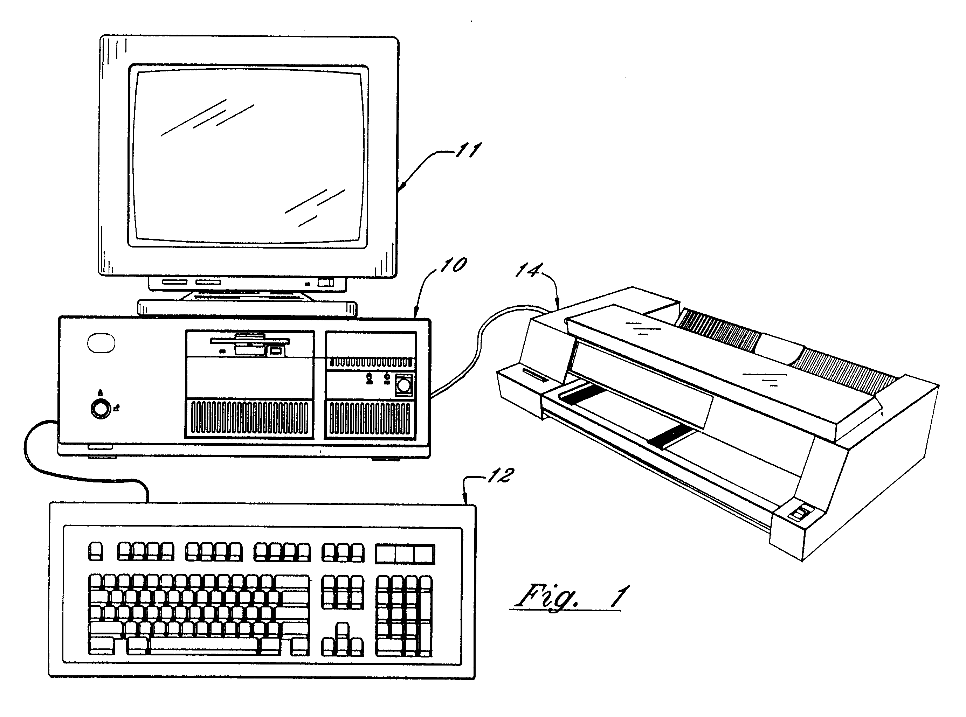

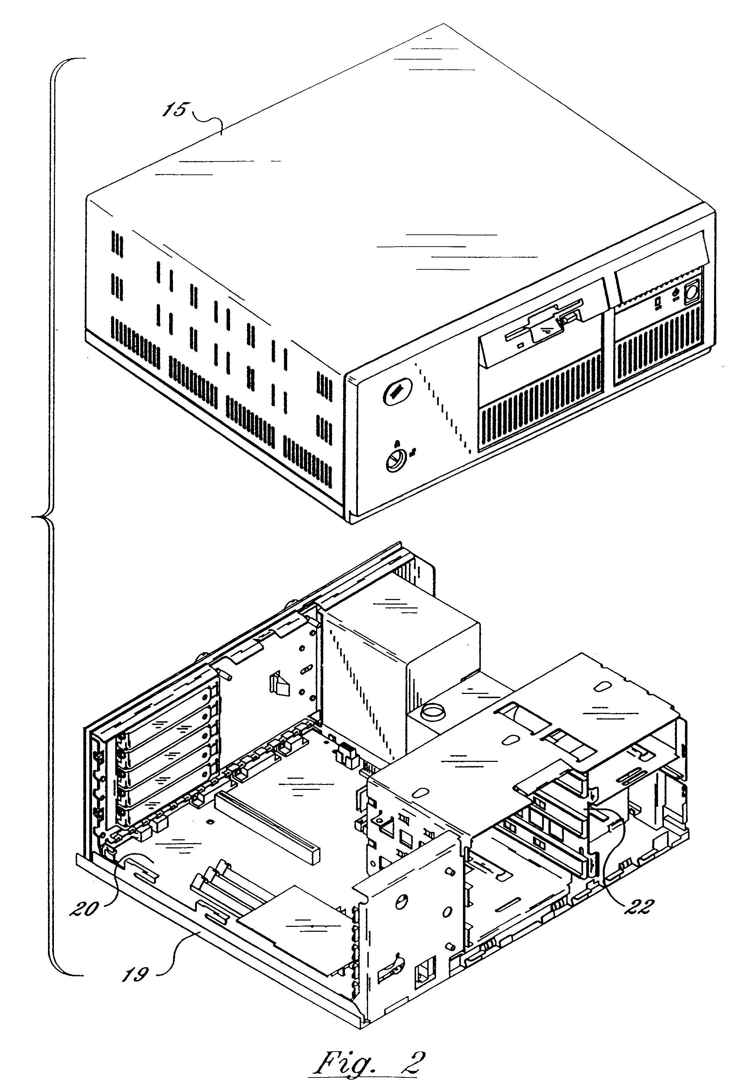

A microcomputer embodying the present invention is shown and generally indicated at 10 (Figure 1). The computer 10 may have an associated display device or monitor 11, keyboard 12 and printer or plotter 14. The computer 10 has a cover 15 which cooperates with a chassis 19 in defining an enclosed, shielded volume for receiving electrically powered data processing and storage components for processing and storing digital data, as shown in Figure 2. At least certain of these components are mounted on a multilayer planar 20 or motherboard which is mounted on the chassis 19 and provides a means for electrically interconnecting the components of the computer 10 including those identified above and such other associated elements as floppy disk drives, various forms of direct access storage devices, accessory cards or boards, and the like.

The chassis 19 has a base and a rear panel (Figure 2) and defines at least one open bay for receiving a data storage device such as a disk drive for magnetic or optical disks, a tape backup drive, or the like. In the illustrated form, an upper bay 22 is adapted to receive peripheral drives of a first size (such as those known as 3.5 inch drives). A floppy disk drive, a removable media direct access storage device capable of receiving a diskette inserted thereinto and using the diskette to receive, store and deliver data as is generally known, may be provided in the upper bay 22.

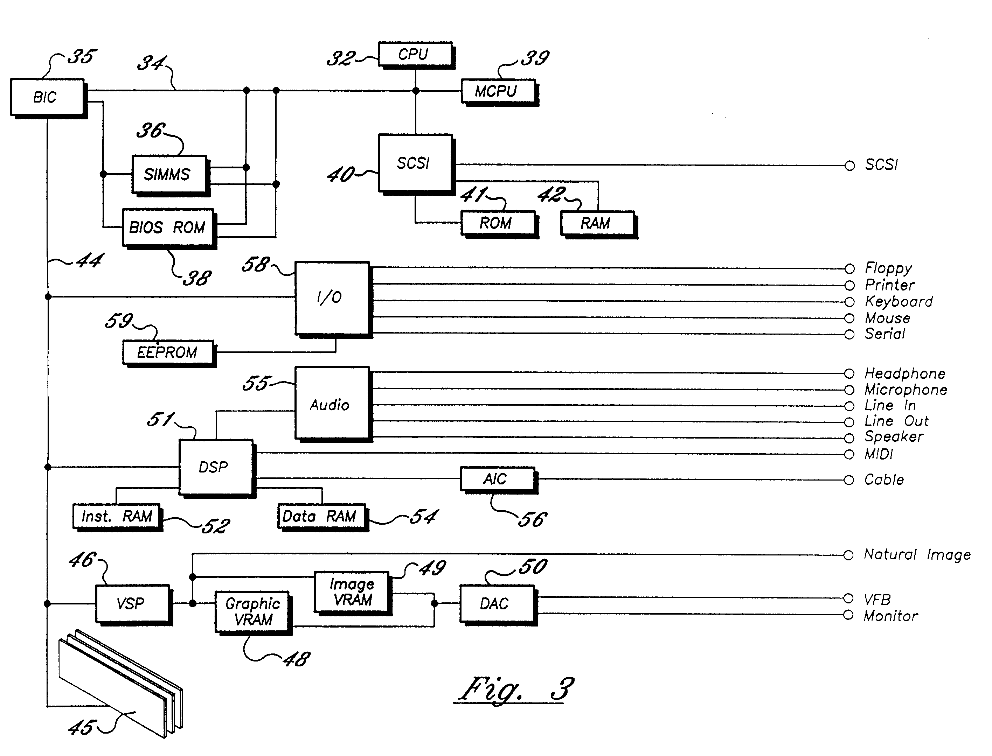

Prior to relating the above structure to the present invention, a summary of the operation in general of the personal computer system 10 may merit review. Referring to Figure 3, there is shown a block diagram of a personal computer system illustrating the various components of the computer system such as the system 10 in accordance with the present invention, including components mounted on the planar 20 and the connection of the planar to the I/O slots and other hardware of the personal computer system. Connected to the planar is the system processor 32. While any appropriate microprocessor can be used as the CPU 32, one suitable microprocessor is the 80386 which is sold by INTEL. The CPU 32 is connected by a high speed CPU local bus 34 to a bus interface control unit 35, to volatile random access memory (RAM) 36 here shown as Single Inline Memory Modules (SIMMs) and to BIOS ROM 38 in which is stored instructions for basic input/output operations to the CPU 32. The BIOS ROM 38 includes the BIOS that is used to interface between the I/O devices and the operating system of the microprocessor 32. Instructions stored in ROM 38 can be copied into RAM 36 to decrease the execution time of BIOS.

While the present invention is described hereinafter with particular reference to the system block diagram of Figure 3, it is to be understood at the outset of the description which follows that it is contemplated that the apparatus and methods in accordance with the present invention may be used with other hardware configurations of the planar board. For example, the system processor could be an Intel 80286 or 80486 microprocessor.

Returning now to Figure 3, the CPU local bus 34 (comprising data, address and control components) also provides for the connection of the microprocessor 32 with a math coprocessor 39 and a Small Computer Systems Interface (SCSI) controller 40. The SCSI controller 40 may, as is known to persons skilled in the arts of computer design and operation, be connected or connectable with Read Only Memory (ROM) 41, RAM 42, and suitable external devices of a variety of types as facilitated by the I/O connection indicated to the right in the Figure. The SCSI controller 40 functions as a storage controller in controlling storage memory devices such as fixed or removable media electromagnetic storage devices (also known as hard and floppy disk drives), electro-optical, tape and other storage devices.

The bus interface controller (BIC) 35 couples the CPU local bus 34 with an I/O bus 44. By means of the bus 44, the BIC 35 is coupled with an optional feature bus such as a MICRO CHANNEL bus having a plurality of I/O slots for receiving MICRO CHANNEL adapter cards 45 which may be further connected to an I/O device or memory (not shown). The I/O bus 44 includes address, data, and control components.

Coupled along the I/O bus 44 are a variety of I/O components such as a video signal processor 46 which is associated with video RAM (VRAM) for storing graphic information (indicated at 48) and for storing image information (indicated at 49). Video signals exchanged with the processor 46 may be passed through a Digital to Analog Converter (DAC) 50 to a monitor or other display device. Provision is also made for connecting the VSP 46 directly with what is here referred to as a natural image input/output, which may take the form of a video recorder/player, camera, etc. The I/O bus 44 is also coupled with a Digital Signal Processor (DSP) 51 which has associated instruction RAM 52 and data RAM 54 available to store software instructions for the processing of signals by the DSP 51 and data involved in such processing. The DSP 51 provides for processing of audio inputs and outputs by the provision of an audio controller 55, and for handling of other signals by provision of an analog interface controller 56. Lastly, the I/O bus 44 is coupled with a input/output controller 58 with associated Electrical Erasable Programmable Read Only Memory (EEPROM) 59 by which inputs and outputs are exchanged with conventional peripherals including floppy disk drives, a printer or plotter 14, keyboard 12, a mouse or pointing device (not shown), and by means of a serial port.

In order to facilitate the use of the system in displaying to a user a series of video images, the system as described to this point has certain characteristics. More specifically, the system 10, having a high speed system processor compatible with application programs and operating system software designed to execute on slower speed system processors, facilitates the storage, retrieval and display of a sequence of a plurality of video images each to be displayed in a predetermined array of pixels arranged in a succession of lines by having the high speed central processor 32 with real and protected modes of operation and coupled to a high speed data bus 34 for handling digital signals also coupled with volatile and non-volatile memory devices 41, 42 for receiving, storing and delivering digital signals which will include digitally encoded video images. A storage controller 40 coupled to the high speed data bus regulates communications between the CPU 32 and storage memory devices capable of storing digital signals of the types here described. Such storage memory devices may be any of a range of types, including magnetic storage media such as removable or "floppy" diskettes or fixed disks or hardfiles and also including optical media such as the digital signal compact diskette read only memory known as CD-ROM. Persons of skill in the applicable computer arts will be familiar with other examples of storage memory devices coming within the scope illustrated by the brief examples given.

In the specific example here given, the system also has a bus interface controller 35 coupled to the high speed data bus 34 for providing communication between the high speed data bus and an input/output data bus 44 and a visual signal processor 46 coupled to one of the buses for processing digital signals transmitted through the buses and related to images to be displayed on the monitor 11 including video images which may be in a series of images. As indicated, the monitor 11 functions as a display device coupled to the visual signal processor 46 for displaying visually images derived from digital signals handled by the processors 32, 46. The processors and memory devices cooperate in providing a series of digital signals representative of a sequence of a plurality of video images each to be displayed in a predetermined array of pixels arranged in a succession of lines, with each digital signal in the series representing a corresponding one video image in a sequence to be displayed. Each digital signal has a first portion which is bit-mask data defining an array of pixels and a second portion which is pixel data defining pixel values for pixels within the bit-mask array and to be displayed. Each successive digital signal in the series for the second and following video images in the sequence being compressed and differs from the immediately preceding one of the signals by having a bit-mask data portion representing which pixels are changed in the succession from the immediately preceding video image to the video image represented by the compressed signal and a pixel data portion representing only those pixels which are represented in the bit-mask portion as being changed. Such compressed digital signals are expanded in sequence, and the sequence of a plurality of video images derived from expanding the compressed digital signals displayed on the monitor 11.

Compression of video image digital signals has been known prior to the present invention. Existing methods differ in the speed at which they compress, as well as in the amount of compression they are able to achieve. Speed of decompression is another variable. Most methods perform better on some types of data than on others, and some discard information during the compression phase while others do not.

Digital video compression methods have, until recently, concentrated on exploiting spatial redundancies within the vertical and horizontal axes of a single image. One of the best general-purpose video compression methods, JPEG, has recently become an international standard. It can produce very good reconstructions of video images from encodings at 15,000 to 30,000 bytes per image. However, the JPEG method does not address the problem of storing sequences of images efficiently. For applications requiring video sequences, such as digital movies or other forms of frame animation (the type of subject matter with which the present invention is particularly concerned), a one-minute sequence at 30 frames per second might require as much as 27 to 54 megabytes using JPEG compression.

The differential image compression method of the present invention enables the playing of digital movies from low-cost storage devices by existing personal computers such as those described above. Differential image compression takes advantage of similarities between images in a sequence by storing information about their differences over time. Several methods are already known (among them are MPEG, DVI, and Apple's "Road Pizza"), but none are as efficient as the one here to be described for storing video sequences both with respect to the number of bytes per image, and with respect to the amount of computation required to decompress an image, while maintaining spatial and color fidelity.

Briefly stated, a sequence is provided of a plurality of video images each to be displayed in a predetermined array of pixels arranged in a succession of lines; a first digital signal is derived which represents a first video image in the sequence to be displayed, the first digital signal having a first portion which is bit-mask data defining an array of pixels and a second portion which is pixel data defining pixel values for pixels within the bit-mask array and to be displayed; a second digital signal is derived which represents a second video image in the sequence to be displayed and which is a successor to the first image, the second digital signal having a first portion which is bit-mask data defining an array of pixels and a second portion which is pixel data defining pixel values for pixels within the bit-mask array and to be displayed; comparing the first and second digital signals are compared to Distinguish pixel data which is unchanged in the succession from the first video image to the second video image; the second digital signal is compressed by deriving the bit-mask data portion of the second digital signal to represent which pixels are changed in the succession from the first video image to the second video image and by deriving the pixel data portion of the second digital signal to represent only those pixels which are represented in the bit-mask portion as being changed; and the series of digital signals is stored.

As indicated, the differential image compression method represents each image in a sequence with a bit-mask and an array of pixel data. There is at most one bit in the bit-mask for each pixel in the original image. If the digital value of a pixel in an image is the same as the value of the pixel at the same location in the previous image in the sequence, then the value of the bit in the bit-mask that corresponds to this pixel is 0. On the other hand, if the value of a pixel is different from its value in the previous image, then the value of its bit in the bit-mask is 1.

Because the images in a sequence of images are shown one after the other, it is not necessary to store or display pixels that have the same value from image to image. Therefore, pixel data for a pixel is stored only when its bit in the bit-mask is 1. Compression is achieved when the value of a pixel is the same from image to image in a sequence, indicated by a 0 in the bit-mask, by eliminating the digital representation of the pixel in the pixel data array of the subsequent image or images.

The size of an image compressed with this method can be calculated as follows. There is one bit in the bit-mask per pixel in the image, plus however many bits of color resolution is desired per pixel for just those pixels that did change from the previous image. Obviously, the more similarity between the pixels in two images, the greater the compression, with the lower limit being a bit-mask of all 0's, and the upper limit being a bit-mask of all 1's plus an array of pixel data with an entry for every pixel.

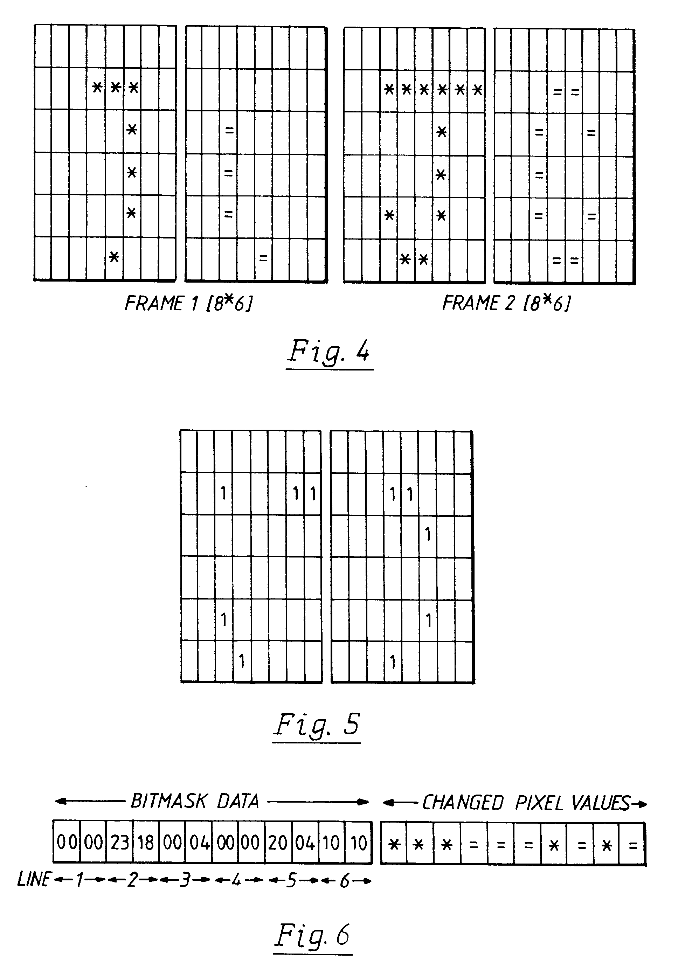

This differential image compression is illustrated in the series of views of Figures 4 through 6. Figure 4 shows a first frame of an image to be displayed, and is the starting point in a series of images as to which digital signals representing the images is compressed. For purposes of simplifying the discussion here given, the following illustration will relate only to the first and second images in a series. It is to be understood that as images are presented for processing seriatim, what has been the second image in a series of two becomes the first for the next series of two, and so forth through any sequence necessary to the presentation being made. Thus Figure 4 also shows the second frame or image in a series of two.

Figure 5 illustrates the bit-mask resulting from comparison of the digital signals for the two images. As will be noted, the differential bit-mask of Figure 5 includes an indicated signal (a "1") only in boxed locations (representative of pixels) where a change has occurred between the image of frame one and the image of frame two in Figure 4. The differential bit-mask data is then joined with data indicative of pixel values to produce the data record or digital signal illustrated in Figure 6 and which has a bit-mask portion indicating which pixels are to be changed and a pixel data portion indicating the new values of the changing pixels.

Further improvements in compression can be achieved by compressing the bit-mask itself. In an area of little change from image to image, such as a static background as viewed by a stable camera, the bit-mask will contain mostly 0's. Areas where lots of motion occurs, either from a moving object or from a moving camera, will contain mostly 1's. Without special filtering, most compressed images will contain bit-masks of alternating 1's and 0's with few runs of any length. However, where runs occur in the bit-mask, they can be compressed.

A particular embodiment of the above-described method will now be described. This is not the only possible implementation of the method, but is given by way of example. This exemplary method proceeds from the top of a two images being compared to the bottom. Each line in the two images is compared from left to right.

First, for each image, an INTEL-format 16-bit WORD is stored which represents the size, in bytes, of the bit-mask. As the maximum value of a WORD is 65535, as each pixel requires one bit, and as 8 bits make up one byte, the maximum area of an image using this embodiment is 65535 x 8 = 524,280 pixels. This is sufficient to represent images with dimensions up to 800x600 pixels. The size of the bit-mask can be added to the starting location of the bit-mask to determine the starting location of the pixel data array.

Next in this particular embodiment, a compressed form of the bit-mask for each horizontal line in the image is stored. The bit-mask is compressed line by line as follows. The bit-mask data for each line begins with a two-byte code. The first byte represents how many bytes of bit-mask data for the current line follow the two-byte code. When there are no bit-mask bytes for a line, i.e., when all the pixel values in a line are the same as the corresponding pixel values in the same line in the previous image, the first byte of the two-byte code will have a value of 0. In this case, the second byte will indicate how many lines have no bit-mask bytes, i.e., how many lines are the same. Since the maximum value of an INTEL byte is 255, we can compress up to 255 lines of pixel data into two bytes, when the lines contain no change from one image to the next. If more lines than this are the same, then another two-byte code can indicate how many more lines to skip, and so no. For example, if two 640x480 images in a sequence were identical, it would require a 16-bit WORD to store the size of the bit-mask, and two two-byte codes to indicate that 480 lines are to be skipped, for a total of six bytes.

When the first byte of the two-byte code is not zero, it equals the number of bit-mask bytes that follow the two- byte code for the current line. In this case, the second byte indicates how many pixels at the left of the current line are the same as in the previous image. In this manner, leading and trailing runs of 0's in the bit-mask can be eliminated. Such runs are likely to occur when motion is greater toward the center of the image sequence and less at the edges, such as when filming a television newscaster. This use of the two-byte code limits line widths to 255 x 8 = 2040 pixels.

When there are bit-mask bytes for a line, they immediately follow the two-byte code. The bits in a bit-mask byte are interpreted as follows. Using the INTEL ordering scheme, the most significant bit in a bit-mask byte is considered to correspond to the leftmost of eight pixels, and the least significant bit corresponds to the rightmost of eight pixels. If there is data for the pixel in the array of pixel data, then the bit has a value of 1; otherwise, it has a value of 0.

For example, suppose a bit-mask byte has a value of 167 decimal, represented in binary format as 10100111. This indicates that there is an entry in the pixel data array for the leftmost pixel, none for the second, data for the third, skip two pixels, and data for the three rightmost pixels.

Each bit-mask byte represents eight pixels. Several bit-mask bytes in order will cover line segments greater than eight pixels. In this case, the interpretation proceeds from the low bit of one bit-mask byte to the high bit of the next bit-mask byte. The last byte in the bit-mask for each line is padded in its low-order bits with 0's when the number of bit-mask bits required by a line is not an exact multiple of 8. In this way, the bits in a bit-mask byte never refer to pixels on more than one line.

The array of pixel data immediately follows the bit-mask bytes. The number of 1-bits in the bit-mask bytes (which does not include the two-byte codes) will equal the number of entries in the array of pixel data. For the example bit-mask byte, 10100111, there would be five entries in the pixel data array.

This implementation represents pixel data as palette table indices. There are 256 colors in the table. Each byte of pixel data is an index into this table.

The computation involved in the comparison, compression, and expansion described hereinabove can be done by the system CPU 32. However, the invention contemplates the possibility that all or assigned portions of the computation can be done by another processor, such as the VSP 46, depending upon choices made by the system designer.

This implementation of the present invention provides the advantages of very good compression on filtered image sequences and good compression on unfiltered image sequences, with extremely fast decompression, minimal computation required to decompress, and the possihility of very good spatial and color fidelity. Additionally, due to the compression achieved, data transfer rates within ranges readily adaptable to known storage devices such as CD-ROM and to known network and other communication protocols are possible opening further applications of digital video. Images compressed using this method cannot be shown out of sequence, unless special processing is performed.

## Claims

1. A digital video image compression method comprising the steps of:
providing a sequence of a plurality of video images each to be displayed in a predetermined array of pixels arranged in a succession of lines;
deriving a first digital signal which represents a first video image in the sequence to be displayed, the first digital signal having a first portion which is bit-mask data defining an array of pixels and a second portion which is pixel data defining pixel values for pixels within the bit-mask array and to be displayed;
deriving a second digital signal which represents a second video image in the sequence to be displayed and which is a successor to the first image, the second digital signal having a first portion which is bit-mask data defining an array of pixels and a second portion which is pixel data defining pixel values for pixels within the bit-mask array and to be displayed;
comparing the first and second digital signals and distinguishing pixel data which is unchanged in the succession from the first video image to the second video image;
compressing the second digital signal by deriving the bit-mask data portion of the second digital signal to represent which pixels are changed in the succession from the first video image to the second video image and by deriving the pixel data portion of the second digital signal to represent only those pixels which are represented in the bit-mask portion as being changed and compressing the bit-mask portion of the second digital signal by deriving a bit-mask portion to represent the absence and presence of pixel data required for successive pixels and the number of any successive pixels for which pixel data is absent; and
storing the series of digital signals.

2. A method according to Claim 1 and further comprising the step of repeating the steps of deriving digital signals, comparing digital signals, compressing digital signals, and storing digital signals for a progression of a plurality of video images following the first and second video images; and wherein the second video image and digital signal advance to become the first video image and digital signal and a new video image and digital signal become the second video image and digital signal as the progression proceeds.

3. A method according to Claim 1 or 2 wherein the step of compressing the second digital signal further comprises the step of compressing the bit-mask portion of the second digital signal by deriving a bit-mask portion to represent the absence and presence of bit-mask data required for successive pixels and the number of any successive pixels for which bit-mask data is absent.

4. A method according to Claim 1, 2 or 3 comprising the further steps of:
retrieving the stored series of digital signals;
expanding compressed digital signals; and
displaying the sequence of a plurality of video images derived from expanding the compressed digital signals.

5. A personal computer system having a high speed system processor compatible with application programs and operating system software designed to execute on slower speed system processors, said personal computer system facilitating the storage, retrieval and display of a sequence of a plurality of video images each to be displayed in a predetermined array of pixels arranged in a succession of lines and comprising:
a high speed central processor having a real and a protected mode of operation and being coupled to a high speed data bus for handling digital signals;
a volatile memory device coupled to the high speed data bus for receiving, storing and delivering digital signals;
a non-volatile memory device coupled to the high speed data bus for receiving, storing and delivering digital signals;
a storage controller coupled to the high speed data bus for regulating communications between said high speed microprocessor and storage memory devices;
a storage memory device coupled to said storage controller for receiving, storing and delivering digital signals;
a bus interface controller coupled to the high speed data bus for providing communications between the high speed data bus and an input/output data bus;
a visual signal processor coupled to one of the buses for processing digital signals transmitted through the buses; and
a display device coupled to said visual signal processor for displaying visually images derived from digital signals handled by said processors;
said processors and memory devices cooperating for providing a series of digital signals representative of a sequence of a plurality of video images each to be displayed in a predetermined array of pixels arranged in a succession of lines, each digital signal in the series representing a corresponding one video image in a sequence to be displayed and comprising a first portion which is bit-mask data defining an array of pixels, the bit-mask portion being compressed and representing the absence and presence of pixel data required for successive pixels and the number of any successive pixels for which pixel data is absent, and a second portion which is pixel data defining pixel values for pixels within the bit-mask array and to be displayed, and each successive digital signal in the series for the second and following video images in the sequence being compressed and differing from the immediately preceding one of the signals by comprising a bit-mask data portion representing which pixels are changed in the succession from the immediately preceding video image to the video image represented by the compressed signal and a pixel data portion representing only those pixels which are represented in the bit-mask portion as being changed; expanding the compressed digital signals in sequence; and displaying the sequence of a plurality of video images derived from expanding the compressed digital signals.

6. A personal computer system according to Claim 5 wherein the bit-mask portion of the compressed digital signals is compressed and represents the absence and presence of bit-mask data required for successive pixels and the number of any successive pixels for which bit-mask data is absent.
